# EUROPÄISCHE PATENTANMELDUNG

(11) **EP 1 705 780 A1**
(43) Veröffentlichungstag der Anmeldung: **27.09.2006**
(21) Anmeldenummer: 05006403.9
(22) Anmeldetag: 23.03.2005
(51) Int. Cl.: H02K 11/00, H02K 3/40, G01R 31/06

(54) **Ständerteil, Turbogenerator, elektrische Maschine und Verfahren zur potentialfreien Auskopplung von Störsignalanteilen bei einer elektrischen Maschine**

(71) Anmelder: SIEMENS AKTIENGESELLSCHAFT, 80333 München (DE)
(72) Erfinder: Heider, Paul-Heinz, 48249 Dülmen (DE); Schimmelpfennig, Gerhard, 46485 Wesel (DE)

(57) **Zusammenfassung**

Um elektrische Schäden an einer elektrischen Maschine frühzeitig zu erkennen, existieren bislang nur mittelbare Möglichkeiten. Gemäß dem neuen Konzept sieht ein Verfahren zur potentialfreien Auskopplung von Störsignalanteilen (49, 57, 59) bei einer elektrischen Maschine aufweisend eine gegen die Umgebung elektrisch isolierte Wicklung (21) und einen Schaltleitungsverband (29), der zum Schalten der Wicklung (21) potentialgesteuert wird, vor, dass die Störsignalanteile (49, 57, 59) über einen Wandler (41) aus einer Erdverbindung (31) ausgekoppelt werden, über die eine Schaltleitung (27) des Schaltleitungsverbandes (19) geerdet wird. Entsprechend sieht ein Ständerteil (1) eines Turbogenerators, aufweisend ein Ständergehäuse (3) und ein Ständeraktivteil (23) mit einem ferromagnetischen Hohlkörper (22), einer Ständerwicklung (21) und einem Schaltleitungsverband (19), gemäß dem neuen Konzept vor, dass der Schaltleitungsverband (19) potentialgesteuert ist und durch eine elektrische Isolierung gegen den Hohlkörper (22) isoliert ist, und dass eine Schaltleitung (27) des Schaltleitungsverbandes (19) eine Erdverbindung (31) aufweist, und dass ein Wandler (41) zur potentialfreien Auskopplung von Störsignalanteilen (49, 57, 59) an die Erdverbindung (31) gekoppelt ist.

## Beschreibung

Die Erfindung betrifft ein Ständerteil eines Turbogenerators, aufweisend ein Ständergehäuse und ein Ständeraktivteil mit einem ferromagnetischen Hohlkörper, einer Ständerwicklung und einem Schaltleitungsverband. Die Erfindung betrifft auch einen entsprechenden Turbogenerator mit Läuferteil. Die Erfindung führt auch auf eine elektrische Maschine sowie ein Verfahren zur potentialfreien Auskopplung von Störsignalanteilen bei einer elektrischen Maschine.

Ein Turbogenerator weist in der Regel einen Läufer mit einer Läuferwicklung auf, wobei der Läufer innerhalb eines Turbogeneratorständerteils angeordnet ist. Das Turbogeneratorständerteil weist ein Ständergehäuse und ein Ständeraktivteil mit einem ferromagnetischen Hohlkörper, sowie eine Ständerwicklung und einen Schaltleitungsverband auf. Der ferromagnetische Hohlkörper ist in der Regel durch das sogenannte Ständerblechpaket gebildet, in das die Ständerwicklung eingelegt ist. Die Strombeaufschlagung der Ständerwicklung wird über den potentialgesteuerten Schaltleitungsverband gegeben. Die Ständerwicklung ist beispielsweise mit Spannungen bei 21 kV beaufschlagt, um ein entsprechendes Magnetfeld zusammen mit dem ferromagnetischen Hohlkörper zu erzeugen, in dem sich der Läufer durch eine Turbine angetrieben dreht.

Die Isolierung der Ständerwicklung und des Schaltleitungsverbandes ist von wesentlicher Bedeutung für die funktionsgerechte Arbeitsweise des Ständerteils und insbesondere des Turbogenerators im Betrieb. Es hat sich gezeigt, dass insbesondere metallische Kleinteile vor allem in den vom Ständeraktivteil erzeugten Wechselfeldern hin- und herwandern und auf diese Weise die Isolierung nachhaltig beschädigen können. Darüber hinaus kann die Isolierung thermisch oder chemisch und infolge von Alterungsprozessen angegriffen werden. Im Falle einer fehlerhaften Isolierung kann es zu einem Spannungskurzschluss zwischen der Ständerwicklung bzw. dem Schaltleitungsverband einerseits sowie dem ferromagnetischen Hohlkörper andererseits kommen. Im Extremfall würde dies zur schwerwiegenden Beschädigung des Ständeraktivteils führen. Es hat sich nun gezeigt, dass Störsignalanteile, insbesondere Störspannungssignalanteile, bei einem Ständerteil und/oder einem Turbogenerator der eingangs genannten Art ein wichtiges Mittel zur frühzeitigen Erkennung von Isolierungsbeschädigungen oder Schädigungen allgemeiner Art betreffend die Ständerwicklung und/oder den Schaltleitungsverband darstellen. Ganz allgemein betrifft dies auch eine elektrische Maschine, die eine gegen die Umgebung elektrisch isolierte Wicklung und einen Schaltleitungsverband aufweist. Dies kann beispielsweise neben einem Generator auch ein Transformator oder ein Motor sein.

Die Möglichkeit hochfrequente Störspannungssignale aus elektrischen Maschinen und Geräten auszukoppeln wird zur Zeit an einer Vielzahl von Generatoren weltweit genutzt. Wie erläutert, besteht der Zweck darin, elektrische Schäden in Generatoren oder anderen elektrischen Maschinen wie Transformatoren oder Motoren oder im Ableitungsbereich der elektrischen Maschine frühzeitig zu erkennen.

Bekannt ist, die Auskopplung von Störsignalanteilen über Auskoppeleinheiten (so genannte AKV's) oder Ringkernwandler (Stromzangen) vorzunehmen, die jedoch nicht direkt am Generator oder einer anderen elektrischen Maschine angebracht sind, sondern lediglich zwischen Generator und Maschinentransformator angeordnet sind. Eine Ortung der Störquelle erscheint deshalb im Fehlerfall äußerst schwierig.

In einer anderen Vorgehensweise werden Störsignalanteile von Wassersammelringen einer Wasserkühlung bei wassergekühlten Generatoren abgenommen. Die Wassersammelringe empfangen Signale jedoch lediglich nach dem Antennenprinzip, so dass eine direkte elektrische Ankopplung der Wassersammelringe an den Generator nicht gegeben ist. Dementsprechend kommen die ermittelten Störsignalanteile lediglich mittelbar durch eine Antennenkopplung an die Generatorständerwicklung zustande und sind dementsprechend wenig aussagekräftig.

Eine weitere Möglichkeit zur Auskopplung von Störsignalanteilen besteht über das Erregerlager oder den Sternpunkt einer Generatorständerwicklung. Diese Messstellen werden zwar als "generatornah" bezeichnet, können jedoch konstruktionsbedingt lediglich über einen das Erregerlager oder den Sternpunkt bedeckenden Ölfilm ausgekoppelt werden. Entsprechende Störsignalanteile sind also von der Ankoppelart abhängig und dementsprechend fehlerbelastet.

In jedem der oben genannten Fälle ist eine Ortung der Störquelle im Fehlerfall schwierig und darüber hinaus ist die Früherkennung einer Fehleranfälligkeit überhaupt nur bedingt gegeben, da die ausgewerteten üblichen Störsignalanteile, wie erläutert, wenig aussagekräftig sind.

Wünschenswert wäre es, ein gleichzeitig verlässliches wie auch aussagekräftiges Konzept zur frühzeitigen Erkennung elektrischer Schäden an einer elektrischen Maschine und insbesondere einem Ständerteil eines Turbogenerators zur Verfügung zu stellen.

An dieser Stelle setzt die Erfindung an, deren Aufgabe es ist, eine Vorrichtung und ein Verfahren zur potentialfreien Auskopplung von Störsignalanteilen bei einer elektrischen Maschine anzugeben.

Hinsichtlich der Vorrichtung wird die Aufgabe zunächst durch eine elektrische Maschine, aufweisend eine gegen die Umgebung elektrisch isolierte Wicklung und einen Schaltleitungsverband, der zum Schalten der Wicklung potentialgesteuert ist, gelöst, wobei erfindungsgemäß eine Schaltleitung des Schaltleitungsverbandes eine Erdverbindung aufweist und ein Wandler zur potentialfreien Auskopplung von Störsignalanteilen an die Erdverbindung gekoppelt ist.

Die Aufgabe hinsichtlich der Vorrichtung wird auch durch ein Ständerteil eines Turbogenerators der eingangs genannten Art gelöst, bei dem erfindungsgemäß
- der Schaltleitungsverband potentialgesteuert ist und gegen den Hohlkörper elektrisch isoliert ist; und
- eine Schaltleitung des Schaltleitungsverbandes eine Erdverbindung aufweist; und
- ein Wandler zur potentialfreien Auskopplung von Störsignalanteilen an die Erdverbindung gekoppelt ist.

Die Erfindung hat dabei erkannt, dass es für eine gleichzeitig verlässliche als auch aussagekräftige Ermittlung eines Störsignalanteils nicht nur die Möglichkeit einer generatornahen Störsignalanteilauskopplung gegeben sein sollte, sondern darüber hinaus eine möglichst direkte elektrische Kopplung an die Ständerwicklung oder den Schaltleitungsverband erfolgen sollte. Dies wird gemäß der Erfindung dadurch erreicht, dass der Wandler zur potentialfreien Auskopplung von Störsignalanteilen direkt an eine Erdverbindung gekoppelt ist, die mit einer Schaltleitung des Schaltleitungsverbandes verbunden ist, und die wiederum die Ständerwicklung strombeaufschlagt. Die Kopplung kann dabei kapazitiv und/oder induktiv erfolgen und stellt somit eine direkte elektrische Kopplung an die Ständerwicklung und/oder den Schaltleitungsverband dar.

Damit wird ein lang ersehntes Ziel in der Generatormesstechnik erreicht, nämlich Störsignalanteile, z. B. in Form von Störspannungssignalen, direkt aus einer rotierenden Maschine ein- und/oder auszukoppeln und deren Zustand zu beurteilen. Erstmals wird eine gleichzeitig verlässliche als auch aussagekräftige Möglichkeit gegeben, eine einsetzende Alterung, insbesondere eine Alterung einer Isolierung eines Ständerteils frühzeitig zu erfassen und beurteilen zu können. Die Auskopplung von Störsignalanteilen gemäß dem hier vorgestellten Konzept bietet darüber hinaus die Möglichkeit, Störsignalanteile nicht nur frühzeitig zu erkennen, sondern dieselben auch zu lokalisieren und sehr kleine Störsignalanteile zu erfassen. Voraussetzung für beides ist die von dem neuen Konzept vorgesehene direkte Ankopplung des Wandlers an die mit der Ständerwicklung und dem Schaltleitungsverband elektrisch verbundene Erdverbindung.

Mit anderen Worten nutzt das hier vorgeschlagene Konzept eine direkte elektrische Ankopplung an eine mit der Ständerwicklung und Schaltleitungsverband elektrisch verbundenen Erdverbindung.

Vorteilhafte Weiterbildungen der Erfindung sind den Unteransprüchen zu entnehmen und geben im Einzelnen vorteilhafte Möglichkeiten an, das Ständerteil und ggf. andere elektrische Maschinen gemäß dem neuen Konzept zur Erreichung der damit verbundenen Vorteile weiterzubilden.

Vorzugsweise ist der Wandler in Form eins Ringkernstromwandlers gebildet, beispielsweise in Form eines Transformators. Auf diese Weise können die Störsignalanteile induktiv ausgekoppelt werden und vorzugsweise auf 50 Hz oder Drehstromnetzfrequenz transformiert werden. Dabei hat es sich als vorteilhaft erwiesen, den Wandler in Form eines hochfrequenten Wandlers als Hochpass auszubilden, der nur hochfrequente Störsignalanteile aus der Erdverbindung weitergibt. Dies hat den Vorteil, dass praktisch nur die für eine Messauswertung nützlichen Störsignalanteile weitergegeben werden. Der Wandler ist dazu vorzugsweise mit einer Messaufnahmevorrichtung für die Störsignalanteile verbunden.

Gemäß einer besonders bevorzugten Weiterbildung umschließt der Transformator die Erdverbindung, indem der Transformator eine Öffnung aufweist, durch welche die Erdverbindung geführt ist. Dabei ist der Transformator zur flexiblen und leichten Anbringung oder Abnahme vorzugsweise auf- und zuklappbar. Eine derartige Anordnung des Wandlers führt auch dazu, dass hochfrequente Störsignalanteile, die insbesondere für eine Beschädigung einer Isolierung aussagekräftig sind, direkt einer Messaufnahmevorrichtung zugeführt werden können.

Insbesondere ist die Erdverbindung flexibel, also biegsam, ausgebildet und durch eine Durchführung durch das Ständergehäuse vom Gehäuseinneren zum Gehäuseäußeren des Ständergehäuses geführt. Vorzugsweise ist die Erdverbindung am Gehäuseäußeren befestigt, beispielsweise mit einer Schraube. An einer derartigen flexiblen Erdverbindung lässt sich ein Wandler auf die oben genannte Weise besonders leicht und vielseitig anbringen.

Ein Schaltleitungsverband eines Ständerteils eines Turbogenerators weist vorzugsweise sechs Schaltleitungen auf. Ganz allgemein kann in einer ersten Variante jede Schaltleitung des Schaltleitungsverbandes eine von den anderen Schaltleitungen getrennte Durchführung aufweisen. Dies hat den Vorteil, dass eine direkte Aussage über einen schadhaften Strang einer Ständerwicklung eines Ständerteils des Turbogenerators getroffen werden kann, da für jede Schaltleitung getrennt eine Auskopplung der Störsignalanteile erfolgen kann.

In einer einfacheren, aber gleichwohl vorteilhaften Variante weisen alle Schaltleitungen des Schaltleitungsverbandes eine gemeinsame Durchführung auf. Dies erfordert weniger Konstruktionsaufwand.

Die Erfindung führt auch auf einen Turbogenerator mit einem Läuferteil und einem Ständerteil der oben erläuterten Art.

Die Aufgabe hinsichtlich des Verfahrens wird durch ein Verfahren zur Auskopplung von Störsignalanteilen bei einer elektrischen Maschine, insbesondere einem Turbogenerator mit einem Ständerteil der oben genannten Art gelöst, wobei die Maschine eine gegen die Umgebung elektrisch isolierte Wicklung und einen Schaltleitungsverband aufweist, der zum Schalten der Wicklung potentialgesteuert wird. Dabei werden erfindungsgemäß die Störsignalanteile über einen Wandler aus einer Erdverbindung potentialfrei ausgekoppelt, wobei über die Erdverbindung eine Schaltleitung des Schaltleitungsverbandes geerdet wird.

Die oben genannten Vorteile betreffend das Ständerteil werden ebenfalls durch das Verfahren gemäß dem neuen Konzept erreicht.

Ausführungsbeispiele werden nachfolgend anhand der Zeichnung im Vergleich zum Stand der Technik, welcher zum Teil ebenfalls dargestellt ist, beschrieben. Die Zeichnung soll die Ausführungsbeispiele nicht maßgeblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbar Lehren wird auf den einschlägigen Stand der Technik verwiesen. Im Einzelnen zeigt die Zeichnung in:
- FIG 1: eine schematische Darstellung einer bevorzugten Ausführungsform eines Ständerteils eines Turbogenerators;
- FIG 2: eine beispielhafte Darstellung eines gemäß dem neuen Konzept direkt über einen Wandler aus einer Erdverbindung potentialfrei ausgekoppelten Signalverlaufs mit Störsignalanteilen im Vergleich zu Signalvarianten von weniger vorteilhaften Methoden, nämlich die eingangs genannten Methoden der Messung über eine zwischen Generator und Maschinentransformator angeordnete Ankoppeleinheit sowie über einen Wassersammelring-Erdpunkt ES oder TS.

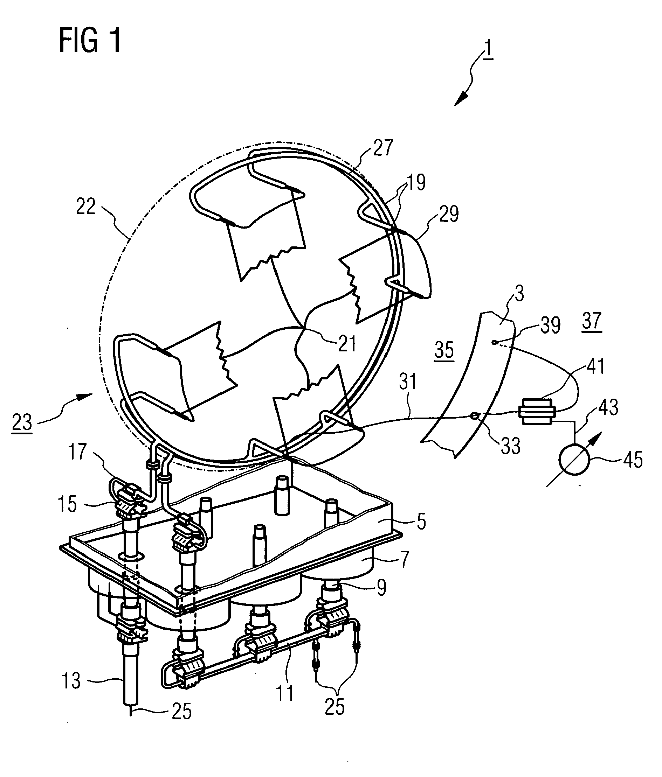

FIG 1 zeigt schematisch das Ständerteil 1 eines nicht näher dargestellten Turbogenerators. Dieses weist zunächst ein Ständergehäuse 3 auf, das in einem Ausschnitt dargestellt ist. Am Ständergehäuse 3 ist außerdem der ausschnittsweise dargestellte Stromdurchführungsknoten 5 angebracht, der eine Anzahl von Stromdurchführungen 7 trägt, die über Stromwandler 9 mit einem Sternpunkt 11 verbunden sind. Neben den Stromdurchführungen 7 trägt der Stromdurchführungsknoten 5 auch einen Phasenabgang 13, der ebenso wie die Stromdurchführungen 7 über plastische Stromverbindungen 15 und so genannte Schlauchleitungen 17 den Schaltleitungsverband 19 und die symbolisch dargestellte Ständerwicklung 21 mit Strom beaufschlagen. Der Schaltleitungsverband 19 und die Ständerwicklung 21 bilden neben dem symbolisch dargestellten ferromagnetischen Hohlkörper 22 das Ständeraktivteil 23. Dabei ist die Ständerwicklung 21 in den ferromagnetischen Hohlkörper 22 eingelegt, der in Form eines nicht näher dargestellten ferromagnetischen Blechpakets gebildet ist. Der mittels den Stromführungen 9 und dem Phasenabgang 13 zugeführte Strom 25 wird potentialgesteuert dem Schaltleitungsverband 19 zugeführt, von dem in FIG 1 beispielhaft eine Schaltleitung 27 mit einer von der Schaltleitung 27 ausgehenden Schlauchleitung 29 dargestellt ist. Sowohl die Schaltleitung 27 selbst als auch die Schlauchleitung 29 sind im Folgenden als Schaltleitung 27 eines Schaltleitungsverbandes 19 zu verstehen. Über die Schaltleitungen 27 bzw. Schlauchleitungen 29 des Schaltleitungsverbandes 19 werden die einzelnen Stränge der Ständerwicklung 21 strombeaufschlagt, von denen vorliegend vier Stränge dargestellt sind. In einer besonders bevorzugten Ausführungsform weist ein Schaltleitungsverband 19 sechs nicht näher dargestellte Schaltleitungen 27 mit entsprechenden Schlauchleitungen 29, wie in der FIG 1 dargestellt, auf.

Aufgrund einer im Bereich mehrerer kV, beispielsweise bei 12 kV, liegenden Spannungsbeaufschlagung der Ständerwicklung 21 ist es für die Funktionsweise des Ständeraktivteils 23 von maßgeblicher Bedeutung, dass sowohl die Ständerwicklung 21 als auch der Schaltleitungsverband 19 hinreichend gegenüber der Umgebung, d.h. insbesondere gegenüber dem nicht näher dargestellten Ständerblechpaket zur Bildung eines ferromagnetischen Hohlkörpers 22 durch eine elektrische Isolierung isoliert sind. Eine Beschädigung oder eine sich ankündigende Leckage der Isolierung macht sich durch einen Störsignalanteil in dem im Ständeraktivteil 23 geführten Strom 25 bemerkbar. Bislang gibt es kein Konzept derartige Störsignalanteile, vorzugsweise in Form eines Störspannungsanteils, hinreichend zuverlässig und aussagekräftig beim Ständeraktivteil zu messen.

Das vorliegende Konzept schlägt mit der in FIG 1 dargestellten, besonders bevorzugten Ausführungsform eines Ständerteils 1 vor, eine Schaltleitung 27 und/oder eine Schlauchleitung 29 oder eine andre vorliegend nicht im Einzelnen dargestellte Schaltleitung des Schaltleitungsverbandes 19 mit einer Erdverbindung 31 zur Erdung zu versehen. Eine solche Erdverbindung ist vorzugsweise biegsam bzw. flexibel ausgeführt und wird bei der in FIG 1 dargestellten besonders bevorzugten Ausführungsform mittels einer Durchführung 33 vom Gehäuseinneren 35 zum Gehäuseäußeren 37 geführt und ist am Gehäuseäußeren 37 an einer geeigneten Stelle 39 am Ständergehäuse 3 geerdet. Mit Hilfe eines Wandlers 41, insbesondere eines Hochfrequenzringkernstromwandlers in Form eines Transformators werden hochfrequente Störsignalanteile über eine Messdatenleitung 43 einer Messaufnahmevorrichtung 45 zugeführt. Die Störsignalanteile sind vorliegend in Form von Störspannungsanteilen gebildet und die Messaufnahmevorrichtung 45 weist dazu ein Spannungsmessgerät auf. Der hochfrequente Ringkernstromwandler 41 in Form eines Transformators transformiert die Störsignalanteile auf vorliegend 50 Hz, alternativ auch auf eine Drehstromnetzfrequenz, und wirkt auf diese Weise als Hochpassfilter.

Die hier dargestellte, besonders bevorzugte Ausführungsform erlaubt es bereits sehr kleine Störsignalanteile frühzeitig zu erkennen und zu lokalisieren. Dies erfolgt vorliegend insbesondere dadurch, dass jede einzelne Schaltleitung 27 der insgesamt sechs und nicht weiter dargestellten weiteren Schaltleitungen des Schaltleitungsverbandes 19 eine von den anderen Schaltleitungen getrennte Erdverbindung 31 durch eine entsprechende Durchführung 33 aufweist. Dies hat den Vorteil, dass eine direkte Aussage über den von einer Isolierungsstörung betroffenen Strang einer Ständerwicklung 21 getroffen werden kann, welcher jeweils einer Schaltleitung 27 bzw. einer daran angeschlossenen Schlauchleitung 29 zugeordnet ist. Ein Störsignalanteil wird bei der hier dargestellten Ausführungsform also getrennt für jeden Strang einer Ständerwicklung 21, d.h. für jede Schaltleitung 27 mit zugeordneten Schlauchleitungen 29 separat, über eine zugeordnete Erdverbindung 31 direkt aus der Erdverbindung 31 ausgekoppelt. Dies hat den Vorteil, dass sich die ermittelten Messwerte auch einer bestimmten Phase der Ständerwicklung zuordnen lassen. Die Auskopplung erfolgt vorliegend induktiv durch den als Transformator ausgeführten Ringkernstromwandler 41.

Neben den bereits genannten Vorteilen erlaubt es die hier beschriebene Ausführungsform auch sich anbahnende elektrische Störquellen im asynchronen Leerlauf bei erregtem Ständeraktivteil 23 zu messen. Dieses ist ein lang gehegtes Ziel der Generatormesstechnik, nämlich Störspannungssignale direkt aus einer rotierenden Maschine ein- und/oder auszukoppeln und deren Zustand zu beurteilen.

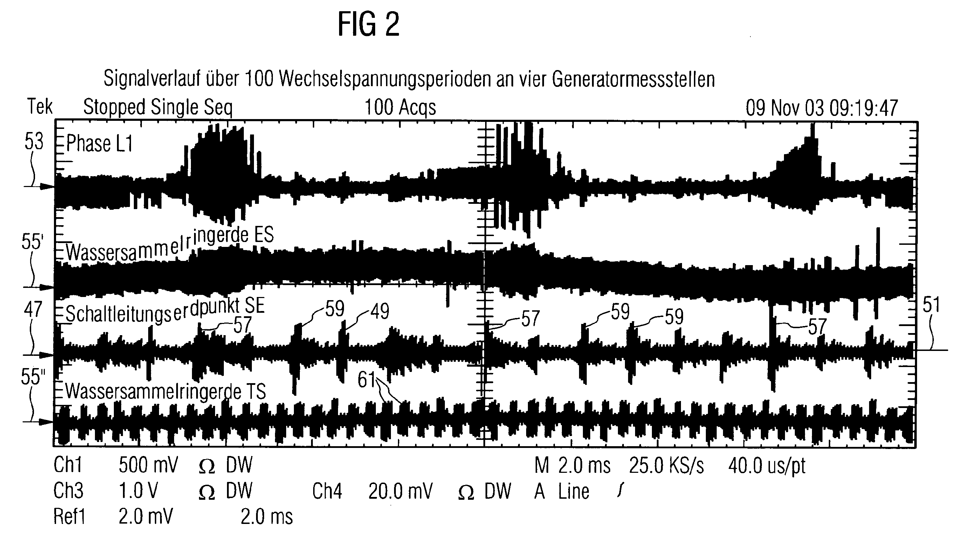

Ein Beispiel eines Signalverlaufs 47 mit einem Störsignalanteil 49, 57, 59 ist in der dritten Zeile der FIG 2 unter der Überschrift "Schaltleitungserdpunkt SE" beispielhaft dargestellt. Gezeigt ist der Signalverlauf über hundert Wechselspannungsperioden. Der mit dem Bezugszeichen 47 versehene Störsignalanteil wurde ermittelt, indem der Störsignalanteil, wie in FIG 1 beschrieben, über einen Wandler 41 aus einer Erdverbindung 31 potentialfrei ausgekoppelt wird, wobei über die Erdverbindung 31 eine Schaltleitung 27 des Schaltleitungsverbandes 19 geerdet wird. Der Störsignalanteil 47 wird über eine Messdatenleitung 43 einer Messaufnahmevorrichtung 45 zugeführt und kann auf einem Ausgabemedium in der mit dem Bezugszeichen 47 versehenen Form eines Signalverlaufs dargestellt werden. Wie am Signalverlauf 47 zu erkennen ist, zeigen sich Störsignalanteile 49 in unterschiedlichster Art. Die Störsignalanteile 49 sind im Wesentlichen als Ausschlag zur Nulllinie 51, d.h. ohne Untergrund, zu erkennen. Außerdem heben sich die Störverläufe 49 deutlich gegenüber dem üblichen Signalverlauf 47 ab, so dass sie aussagekräftig analysiert werden können, um Rückschlüsse beispielsweise auf eine schadhafte Isolierung der Ständerwicklung 21 oder des Schaltleitungsverbandes 19 zuzulassen.

Im Vergleich zu dem gemäß dem mit der besonders bevorzugten Ausführungsform der FIG 1 ermittelten Signalverlauf 47 sind weitere Signalverläufe 53 sowie 55' und 55'' in der FIG 2 gezeigt. Der mit dem Bezugszeichen 53 versehene Signalverlauf wurde zwischen Generator und Maschinentransformator direkt an einem Leiter L1, L2, L3 (vorliegend L1) ausgekoppelt und der Messaufnahmevorrichtung zugeführt. Dies lässt jedoch keine Ortung der Störquelle im Fehlerfall zu. Außerdem zeigt sich im Vergleich zum Signalverlauf 47 gemäß der besonders bevorzugten Ausführungsform, dass lediglich die stärkeren Störsignalanteile 49 zu erkennen sind und diese auch nur in einer sehr verschwommenen Weise. Schwächere Störsignalanteile, wie die mit dem Bezugszeichen 59 versehenen, sind nur klein und fast nicht erkennbar zu vermuten. Eine umfassende Fehleranalyse lässt sich am Signal 53 der Phase L1 kaum ermitteln.

Die in den Signalverläufen 55' und 55'' dargestellten Störsignalanteile sind den Wassersammelringen ES 55' und TS 55" entnommen. Die Wassersammelringe empfangen dabei gemäß dem Antennenprinzip Signale der Ständerwicklung 21 des Ständerteils 1 des Turbogenerators. Am Signalverlauf 55' lässt sich kaum ein signifikanter Störanteil erkennen. Am Signalverlauf 55" ist lediglich eine periodische Wiederholung von Anteilen 61 zu erkennen, die keinerlei Möglichkeit geben, einen Störsignalanteil zu identifizieren.

Zusammenfassend lässt sich feststellen, dass das in Zusammenhang mit FIG 1 und FIG 2 beschriebene Verfahren zur potentialfreien Auskopplung von Störsignalanteilen 49, 57, 59 über einen Wandler 41 aus einer Erdverbindung 31 einer Schaltleitung 27 hinsichtlich Verlässlichkeit und Aussagefähigkeit üblichen Verfahren vorzuziehen ist. Übliche Verfahren zeigen nämlich, wie am Signalverlauf 53 zu erkennen ist, nur massive Störsignalanteile 57. Bei anderen Methoden ist, wie am Signalverlauf 55' zu ermitteln, ein Störverlauf entweder gar nicht zu erkennen, oder, wie am Signalverlauf 55'' zu erkennen, kaum von anderen zu unterscheiden.

Um elektrische Schäden an einer elektrischen Maschine frühzeitig zu erkennen, existieren bislang nur mittelbare Möglichkeiten. Gemäß dem neuen Konzept sieht ein Verfahren zur potentialfreien Auskopplung von Störsignalanteilen 49, 57, 59 bei einer elektrischen Maschine aufweisend eine gegen die Umgebung elektrisch isolierte Wicklung 21 und einen Schaltleitungsverband 29, der zum Schalten der Wicklung 21 potentialgesteuert wird, vor, dass die Störsignalanteile 49, 57, 59 über einen Wandler 41 aus einer Erdverbindung 31 ausgekoppelt werden, über die eine Schaltleitung 27 des Schaltleitungsverbandes 19 geerdet wird. Entsprechend sieht ein Ständerteil 1 eines Turbogenerators, aufweisend ein Ständergehäuse 3 und ein Ständeraktivteil 23 mit einem ferromagnetischen Hohlkörper 22, einer Ständerwicklung 21 und einem Schaltleitungsverband 19, gemäß dem neuen Konzept vor, dass der Schaltleitungsverband 19 potentialgesteuert ist und durch eine elektrische Isolierung gegen den Hohlkörper 22 isoliert ist, und dass eine Schaltleitung 27 des Schaltleitungsverbandes 19 eine Erdverbindung 31 aufweist, und dass ein Wandler 41 zur potentialfreien Auskopplung von Störsignalanteilen 49, 57, 59 an die Erdverbindung 31 gekoppelt ist.

## Patentansprüche

1. Ständerteil (1) eines Turbogenerators, aufweisend ein Ständergehäuse (3) und ein Ständeraktivteil (23), mit einem ferromagnetischen Hohlkörper (22), einer Ständerwicklung (21) und einem Schaltleitungsverband (19),
**dadurch gekennzeichnet, dass**
- der Schaltleitungsverband (19) potentialgesteuert ist und gegen den Hohlkörper (22) elektrisch isoliert ist; und
- eine Schaltleitung (27) des Schaltleitungsverbandes (19) eine Erdverbindung (31) aufweist;
- ein Wandler (41) zur potentialfreien Auskopplung von Störsignalanteilen (49, 57, 59) an die Erdverbindung (31) gekoppelt ist.

2. Ständerteil (1) nach Anspruch 1,
**dadurch gekennzeichnet, dass**
der Wandler (41) kapazitiv und/oder induktiv direkt an die Erdverbindung (31) gekoppelt ist.

3. Ständerteil (1) nach Anspruch 1 oder 2,
**dadurch gekennzeichnet, dass**
der Wandler (41) in Form eines Ringkernstromwandlers gebildet ist.

4. Ständerteil (1) nach einem der Ansprüche 1 bis 3,
**dadurch gekennzeichnet, dass**
der Wandler (41) in Form eines hochfrequenten Wandlers als Hochpass wirkt, der nur hochfrequente Störsignalanteile (49, 57, 59) aus der Erdverbindung (31) weitergibt.

5. Ständerteil (1) nach einem der Ansprüche 1 bis 4,
**dadurch gekennzeichnet, dass**
der Wandler (41) in Form eines Transformators gebildet ist.

6. Ständerteil (1) nach Anspruch 5,
**dadurch gekennzeichnet, dass**
der Transformator die Störsignalanteile (49, 57, 59) auf 50-Hz- oder Drehstromnetz-Frequenz transformiert.

7. Ständerteil (1) nach Anspruch 5 oder 6,
**dadurch gekennzeichnet, dass**
der Transformator die Erdverbindung (31) umschließt, indem der Transformator eine Öffnung aufweist, durch welche die Erdverbindung geführt ist, wobei der Transformator zur Anbringung oder Abnahme auf- und zu- klappbar ist.

8. Ständerteil (1) nach einem der Ansprüche 1 bis 7,
**gekennzeichnet durch**
eine mit dem Wandler (41) verbundene Messaufnahmevorrichtung (45) für die Störsignalanteile (49, 57, 59).

9. Ständerteil (1) nach einem der Ansprüche 1 bis 8,
**dadurch gekennzeichnet, dass**
die Erdverbindung (31) flexibel ist und durch eine Durchführung (33) vom Gehäuseinneren (35) zum Gehäuseäußeren (37) geführt ist.

10. Ständerteil (1) nach einem der Ansprüche 1 bis 9
**dadurch gekennzeichnet, dass**
die Erdverbindung (31) am Gehäuseäußeren (37) befestigt ist.

11. Ständerteil (1) nach einem der Ansprüche 1 bis 10,
**dadurch gekennzeichnet, dass**
jede Schaltleitung (17) eines Schaltleitungsverbandes (19) eine von den anderen Schaltleitungen getrennte Erdverbindung (31) aufweist.

12. Ständerteil (1) nach einem der Ansprüche 1 bis 10,
**dadurch gekennzeichnet, dass**
alle Schaltleitungen (17) des Schaltleitungsverbandes (19) eine gemeinsame Erdverbindung (31) aufweisen.

13. Turbogenerator mit einem Läuferteil und einem Ständerteil (1) nach einem der vorhergehenden Ansprüche.

14. Elektrische Maschine, insbesondere Generator, Transformator oder Motor, aufweisend eine gegen die Umgebung elektrisch isolierte Wicklung (21) und einen Schaltleitungsverband (19), der
zum Schalten der Wicklung (21) potentialgesteuert ist, wobei eine Schaltleitung (27) des Schaltleitungsverbandes (19) eine Erdverbindung (31) aufweist;
und ein Wandler (41) zur potentialfreien Auskopplung von Störsignalanteilen (49, 57, 59) an die Erdverbindung (31) gekoppelt ist.

15. Verfahren zur Auskopplung von Störsignalanteilen (49, 57, 59) bei einer elektrischen Maschine, insbesondere einem Generator, einem Transformator oder einem Motor, aufweisend eine gegen die Umgebung elektrisch isolierte Wicklung (21) und einen Schaltleitungsverband (19), der zum Schalten der Wicklung (21) potentialgesteuert wird, wobei die Störsignalanteile (49, 57, 59) über einen Wandler (41) aus einer Erdverbindung (31) potentialfrei ausgekoppelt werden, wobei über die Erdverbindung (31) eine Schaltleitung (27) des Schaltleitungsverbandes (19) geerdet wird.
